# EUROPEAN PATENT APPLICATION

(11) **EP 2 871 777 A1**
(43) Date of publication of application: **13.05.2015**
(21) Application number: 13192414.4
(22) Date of filing: 12.11.2013
(51) Int. Cl.: H03K 17/968

(54) **Switch device for optoelectronically detecting switch positions of a mechanically operable switch of a motor vehicle, steering column switch device, motor vehicle and corresponding method**

(71) Applicant: Valeo Auto-Electric Hungary, 8200 Veszprem (HU)
(72) Inventor: Kupó, Balázs, 8200 Veszprem (HU)
(74) Representative: Pothmann, Karsten

(57) **Abstract**

The invention relates to a switch device (5) for optoelectronically detecting switch positions of a mechanically operable switch (2) of a motor vehicle, including an emitting-receiving pair (6) of a light emitter (7) for emitting light beams (12) and a light receiver (8) for receiving the light beams (12), and including an optical influencing means (10) for influencing an optical propagation path (11) of the light beams (12), wherein upon operating the switch (2) the optical influencing means (10) is movable relative to the light emitter (7) and/or the light receiver (8) between a first position, in which the light receiver (8) receives the light beams (12), and a second position, in which incidence of the light beams (12) on the light receiver (8) is prevented, wherein the switch device (5) has at least two emitting-receiving pairs (6) each of a light emitter (7) and an associated light receiver (8) and respectively has an optical influencing means (10) to each emitting-receiving pair (6), wherein the at least two optical influencing means (10) are formed as surface areas (13) of a common switch element (14) and are movable in common with each other upon operating the switch (2).

## Description

The invention relates to a switch device for optoelectronically detecting switch positions of a mechanically operable switch of a motor vehicle, including an emitting-receiving pair of a light emitter for emitting light beams and a light receiver for receiving the light beams, and including an optical influencing means for influencing an optical propagation path or an optical path of the light beams, wherein the optical influencing means is movable relative to the light emitter and/or the light receiver between a first position, in which the light receiver receives the light beams, and a second position, in which incidence of the light beams on the light receiver is prevented, upon operating the switch. In addition, the invention relates to a steering column switch device with such a switch device, a motor vehicle with such a steering column switch device as well as a corresponding method.

Presently, the interest is in particular directed to a steering column switch of a motor vehicle. It is already prior art to detect or evaluate the switch positions of such a switch with the aid of mechanical contacts. However, they are associated with some wear. In contrast, optoelectronic devices being able to detect the current switch position of the steering column switch on optical way offer a low-wear solution. Such a device is for example known from the document DE 10 2010 022 337 A1.

A device for optoelectronically detecting switch positions of a switch is furthermore known from the document EP 1 421 341 B1. Here, a light emitter is employed, which generates optical light beams, which are received by one or more light receivers depending on the current position of the switch. Here, a shutter can assume three different positions: In a first position of the shutter, the light beams emitted by the light emitter are received by two light receivers. In a second position of the shutter, the light beams are only received by one of the receivers, while the other receiver is covered by the shutter and thus is not able to receive light beams. In a third position, the shutter covers both light receivers such that the light beams are not incident on any one of the light receivers.

From the mentioned prior art according to EP 1 421 341 B1, the circumstance is to be considered disadvantageous that due to the common shutter, the coding possibilities of the switch or the number of state combinations of the receivers are limited. In other words, with a given number of light receivers, only a restricted number of codes can be generated. The number of switch positions, which can be detected, is therefore limited. A further disadvantage is in the lacking possibility of plausibility check upon detecting the switch positions. Namely, it is not possible to provide two light receivers, the states of which are always varied synchronously with each other, namely independently of in which position the switch currently is. Such a redundancy could for example be advantageous upon failure of one light receiver.

It is an object of the invention to provide a switch device improved with respect to the prior art for optoelectronically detecting switch positions of a mechanically operable switch of a motor vehicle, a steering column switch device, a motor vehicle as well as a corresponding method.

According to the invention, this object is solved by a switch device, by a pitman arm switch device, by a motor vehicle as well as by a method having the features according to the respective independent claims. Advantageous implementations of the invention are the subject matter of the dependent claims, of the description and of the figures.

A switch device according to the invention is formed for optoelectronically detecting switch positions of a mechanically operable switch of a motor vehicle. The switch device includes an emitting-receiving pair of a light emitter for emitting light beams and a light receiver for receiving the light beams. An optical influencing means is formed for influencing an optical propagation path and thus an optical path of the light path. By operating the switch, the optical influencing means is moved relative to the light emitter and/or the light receiver between a first position and a second position. In the first position of the influencing means, the light beams are received by the light receiver. In contrast, in the second position, incidence of the light beams on the light receiver is prevented. According to the invention, it is provided that the switch device has at least two mentioned emitting-receiving pairs each of a light emitter and an associated light receiver and respectively has a mentioned optical influencing means to each emitting-receiving pair, and the at least two optical influencing means are formed as surface areas of a common and in particular integrally formed switch element and thus are moved in common with each other upon operating the switch.

The provision of multiple emitting-receiving pairs with each one associated optical influencing means has the advantage that a coded switch device can be provided, in which a higher number of codes or state combinations of the light receivers is possible compared to the prior art. Thus, for example, with three emitting-receiving pairs, overall 2³=8 state combinations of the light receivers or 8 different codes are possible. With a preset number of light receivers, thus, multiple switch states or switch positions of the switch can be detected overall compared to the prior art. On the other hand, it is also possible to provide two light receivers in the switch device according to the invention, the states of which always remain the same and thus are varied synchronously with each other. This in turn has the advantage that the detection of the switch positions of the switch can be made plausible and/or the switch positions of the switch can further be reliably detected after failure of a light receiver or of one of the emitting-receiving pairs. Such an approach of providing two synchronous light receivers with always identical switch states is not possible in the prior art according to EP 1 421 341 B1.

Therein, the frequency of the light beams can be in the spectral range visible to the human or in the invisible spectral range. For example, it can be provided that the light beams are infrared beams.

Preferably, the at least two optical influencing means are formed as surface areas of the common switch element separate from each other and thus detached from each other. This means that a separate and thus individual surface area of the switch element is respectively associated with each emitting-receiving pair and each influencing means (each surface area) thus influences the propagation path of the light beams only in the associated emitting-receiving pair, but not in other emitting-receiving pairs,

Preferably, the respective light receiver is disposed fixedly to the associated light emitter in each of the at least two emitting-receiving pairs. For example, all of the emitting-receiving pairs can be fixedly disposed on a common circuit board. The common switch element, on which the influencing means are disposed, can be supported movably relative to this circuit board and thus relative to all of the emitting-receiving pairs. Preferably, the common switch element is supported displaceably relative to the emitting-receiving pairs - in particular linearly or along an arcuate line. Thus, complicated mechanics for detecting the switch positions of the switch are not required such that the wear can also be minimized. Overall, thus, a particularly robust and reliable switch device can be provided.

As already explained, by providing multiple emitting-receiving pairs with each one associated influencing means, any state combinations of the light receivers can be made possible. Therein, each light receiver can have two different states, wherein the current state of each light receiver is dependent on the current position of the associated influencing means and thus also dependent on the current position of the common switch element. Each influencing means is respectively movable between its first position and its second position, wherein the associated light receiver receives the light beams of the associated light emitter in the first position and the incidence of the light beams on this light receiver is prevented in the second position.

For example, it can be provided that the respective second positions of at least two of the influencing means are achieved in different positions of the common switch element. However, it can also be provided that the respective second positions of at least two of the influencing means are achieved in the same position of the common switch element.

With respect to the influence of the respective propagation paths of the light beams, different embodiments can be provided:
At least one of the influencing means can be formed as a reflection surface, which reflects the light beams of the associated light emitter onto the associated light receiver in its first position and is disposed outside of the light beams of the associated light emitter in its second position. This influencing means is therefore provided in the form of a mirror element, which ensures that the light beams are directly reflected onto the light receiver in its first position. If this mirror element is moved into its second position, thus, reflection of the light beams does no longer occur and the light receiver does not receive light beams. Thus, two states of the light receiver can be particularly reliably realized without much effort.

It is also possible that all of the influencing means are each constituted by such a reflection surface or a mirror element.

On the other hand, it can also be provided that at least one of the emitting-receiving pairs is formed as a light barrier, in which the light beams of the light emitter are immediately oriented to the light receiver. The associated influencing means can be disposed outside of the light beams in its first position such that the light receiver is able to receive the light beams. In contrast, in the second position, the influencing means can be disposed in a clearance between the light emitter and the light receiver such that the light beams are intercepted by the influencing means. Here, the associated surface area of the common switch element can for example be formed of a light absorbing material. This embodiment too has the advantage that two states of the light receiver can be effectively realized without much effort.

It can also be provided that all of the emitting-receiving pairs are formed as such a light barrier.

In addition, the invention relates to a steering column switch device for a motor vehicle, which has a mechanically operable steering column switch as well as a switch device according to the invention for detecting switch positions of the steering column switch.

A motor vehicle according to the invention, in particular a passenger car, includes a steering column switch device according to the invention.

A method according to the invention serves for optoelectronically detecting switch positions of a mechanically operable switch of a motor vehicle by means of a switch device having an emitting-receiving pair of a light emitter and a light receiver as well as an optical influencing means for influencing an optical propagation path of the light beams. Upon operating the switch, the optical influencing means is moved relative to the light emitter and/or the light receiver between a first position, in which the light receiver receives the light beams, and a second position, in which incidence of the light beams on the light receiver is prevented. The switch device includes at least two such emitting-receiving pairs each of a light emitter and an associated light receiver and respectively has an optical influencing means to each emitting-receiving pair, wherein the at least two optical influencing means are formed as surface areas of a common switch element and are moved in common with each other upon operating the switch.

The preferred embodiments presented with respect to the switch device according to the invention and the advantages thereof correspondingly apply to the steering column switch device according to the invention, to the motor vehicle according to the invention as well as to the method according to the invention.

Further features of the invention are apparent from the claims, the figures and the description of figures. All of the features and feature combinations mentioned above in the description as well as the features and feature combinations mentioned below in the description of figures and/or shown in the figures alone are usable not only in the respectively specified combination, but also in other combinations or else alone.

Now, the invention is explained in more detail based on individual preferred embodiments as well as with reference to the attached drawings.

There show:
- Fig. 1: in schematic illustration a steering column switch device according to an embodiment of the invention;
- Fig. 2a and 2b: schematic illustrations for explaining a first principle for varying a state of a light receiver by means of an influencing means;
- Fig. 3a and 3b: schematic illustrations for explaining a second principle for varying the state of the light receiver;
- Fig. 4: in schematic illustration an exploded view of a switch device according to an embodiment of the invention, wherein the above mentioned first principle is used;
- Fig. 5: in schematic illustration a switch element formed in the form of a code plate;
- Fig. 6: in schematic illustration a sectional view through the switch device according to Fig. 4;
- Fig. 7: in schematic exploded view a switch device according to an embodiment of the invention, wherein the above mentioned second principle is used;
- Fig. 8: in schematic illustration a switch element of the device according to Fig. 7; and
- Fig. 9: in schematic illustration a sectional view through the device according to Fig. 7.

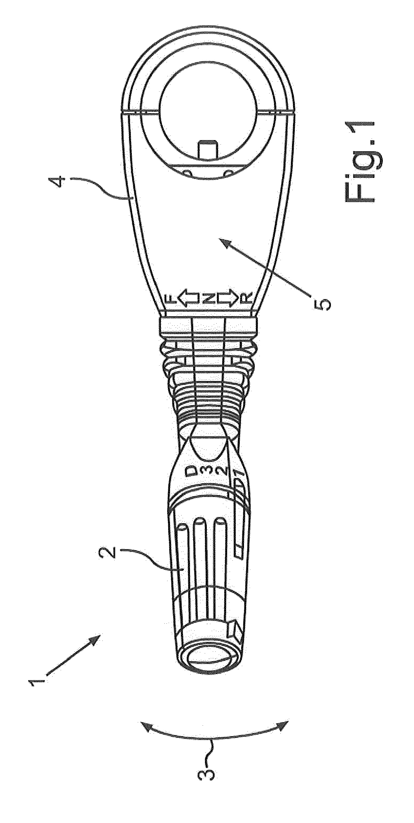

A steering column switch device 1 illustrated in Fig. 1 is conceived for employment in a motor vehicle, in particular a passenger car. In a manner known per se, the steering column switch device 1 includes a mechanically operable steering column switch 2, which can be operated according to the arrow representation 3. For example, the turn signals of the motor vehicle can be activated by means of the steering column switch 2. The steering column switch 2 is pivoted relative to a component 4, in which a switch device 5 according to an embodiment of the invention is disposed. The component 4 has the function of a housing for the switch device 5. The switch device 5 serves for optoelectronically detecting switch positions of the steering column switch 2.

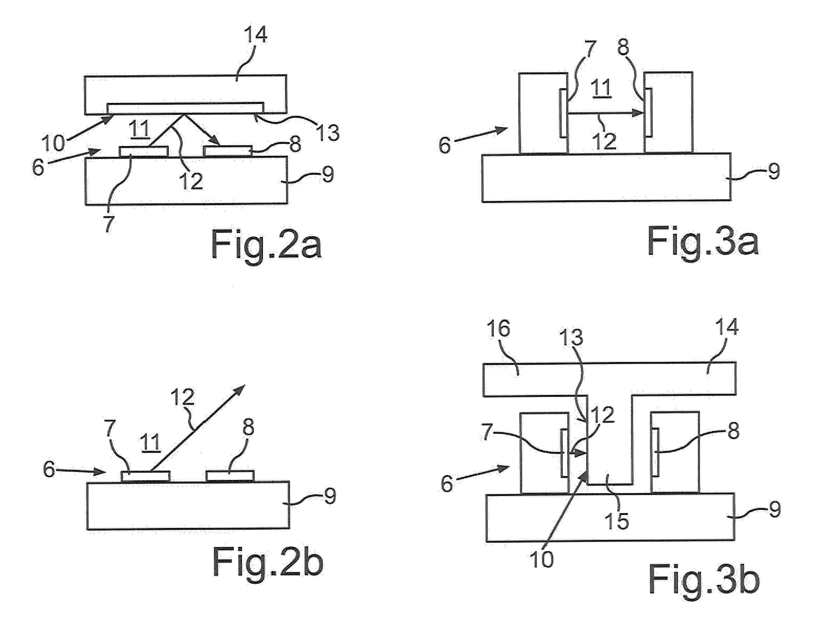

In the switch device 5, multiple emitting-receiving pairs each of a light emitter and an associated light receiver are employed. In order to vary the state of the light receiver depending on the current position of the steering column switch 2, two methods can be used. The first principle for explaining the state of a light receiver is illustrated in Fig. 2a and 2b. An emitting-receiving pair 6 of a light emitter 7 and a light receiver 8 (light sensor) is shown, which are disposed on a circuit board 9. For varying the state of the light receiver 8, an influencing means 10 is provided, which is able to influence an optical path or propagation path 11 of light beams 12, which are emitted by the light emitter 7. The light beams 12 are electromagnetic beams, the frequency of which is for example in the infrared range. According to the first principle, a surface area 13 of a switch element 14 is used as the influencing means 10, which is provided as a reflection surface or in the form of a mirror element. The switch element 14 is moved together with the steering column switch 2 relative to the light emitter 7 and light receiver 8. If the switch element 14 is in a first position illustrated in Fig. 2a, thus, the light beams 12 are reflected on the influencing means 10 or the surface area 13 and then arrive at the light receiver 8. This corresponds to a first state of the light receiver 8.

If the influencing means 10 is moved into a second position, in which for example a passing recess of the switch element 14 is located over the emitting-receiving pair 6, thus, this corresponds to a second state of the light receiver 8, as shown in Fig. 2b. In this second state, the influencing means 10 is not disposed over the emitting-receiving pair 6 such that reflection of the light beams 12 either does not occur. The light receiver 8 therefore does not receive light beams 12.

A second principle is shown in Fig. 3a and 3b. Here, the light emitter 7 on the one hand and the light receiver 8 on the other hand are disposed opposing each other and oriented parallel to the circuit board 9 such that the light beams 12 propagate parallel to the circuit board 9. The light beams 12 are directly oriented to the light receiver 8. Here, the emitting-receiving pair 6 is formed as a light barrier. A first state of the light receiver 8 is shown in Fig. 3a. In this first state, the light receiver 8 receives the light beams 12 in unimpeded manner. Now, if an influencing means 10 is slid into the clearance between light emitter 7 and light receiver 8, thus, it blocks the propagation of the light beams 12 and therefore intercepts the light beams 12. In this second state, the light receiver 8 therefore does not receive light beams 12. In this principle, the influencing means 10 is formed in the form of a surface area 13 of a rib 15 disposed perpendicularly to the circuit board 9, which perpendicularly protrudes from a base body 16 of a switch element 14.

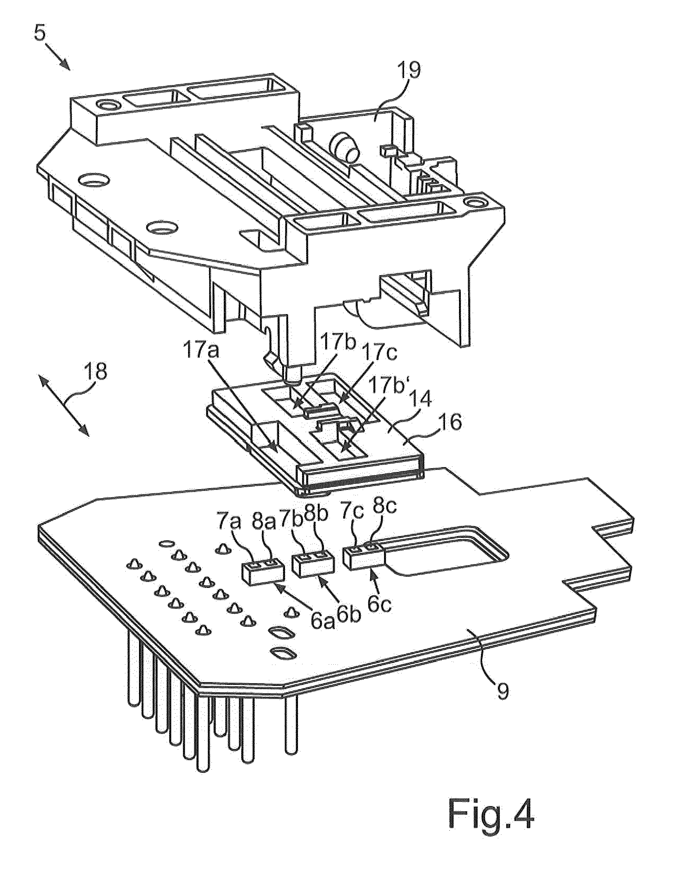

A switch device 5 according to a first embodiment, in which the first principle according to Fig. 2a and 2b is utilized, is explained in more detail below with reference to Fig. 4 to 6:

Fig. 4 shows an exploded view of the switch device 5, which includes a circuit board 9, on which three emitting-receiving pairs 6a, 6b, 6c in total are disposed in the embodiment, which each have a light emitter 7a, 7b, 7c as well as a light receiver 8a, 8b, 8c. The emitting-receiving pairs 6a, 6b, 6c are disposed distributed on the circuit board 9 next to each other. For varying the states of the light receivers 8a, 8b, 8c, the switch device 5 includes a common switch element 14, which is formed as a code plate in the embodiment, which is constituted by a plate-shaped base body 16, in which through-openings 17a, 17b, 17b' and 17c are formed. The through-openings 17 are configured rectangular and elongated. According to the arrow representation 18, the switch element 14 is supported displaceably parallel to the circuit board 9 and is moved together with the steering column switch 2. For supporting and guiding the switch element 14, a bearing part 19 is provided. The through-openings 17 extend parallel to the direction of movement 18.

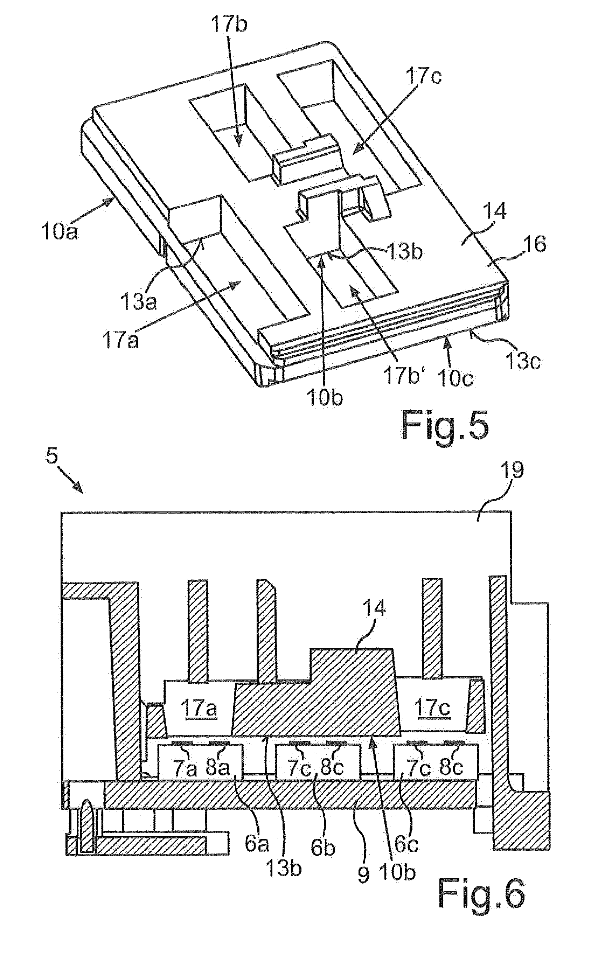

The common switch element 14 or the code plate is shown in Fig. 6 in an enlarged illustration. The common switch element 14 supports all of the influencing means 10a, 10b, 10c, which are here constituted by surface areas 13a, 13b, 13c of the switch element 14 separate from each other (on the bottom of the switch element 14). These surface areas 13a, 13b, 13c constitute reflection surfaces and thus are designed as mirror elements. If the common switch element 14 is moved along the arrow representation 18 according to Fig. 4, thus, it is differentiated between three different positions of the switch element 14 in the embodiment:
- a position, in which only the light receiver 8a of the emitting-receiving pair 6a receives the light beams 12 and the other light receivers 8b, 8c do not receive light beams 12;
- a position, in which only the light receiver 8b receives the light beams 12 of the associated light emitter 7b; and
- a position, in which exclusively the light receiver 8c receives the light beams 12 of the associated light emitter 7c.

Therein, Fig. 6 shows a sectional view of the switch device 5 in a position, in which only the light receiver 8b receives the light beams 12 of the associated light emitter 7b. In this position, the through-opening 17a and thus no reflection surface is located over the first emitting-receiving pair 6a. Over the third emitting-receiving pair 6c too, there is the associated through-opening 17c and thus no reflection surface.

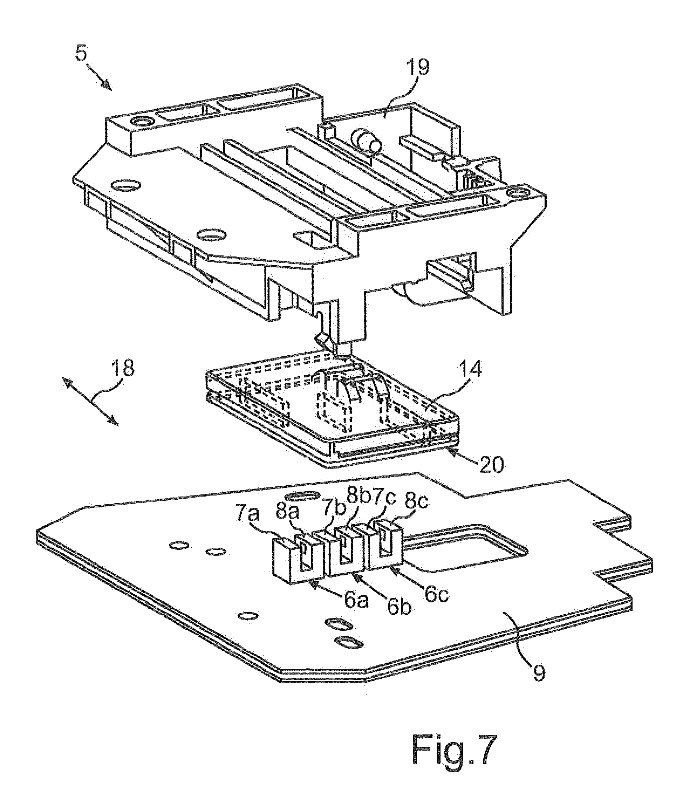

A switch device 5 according to a second embodiment, in which the second principle according to Fig. 3a and 3b is used, is explained in more detail below with reference to Fig. 7 to 9. Here too, the switch device 5 includes a circuit board 9, on which three emitting-receiving pairs 6a, 6b, 6c in total are disposed in the embodiment, wherein these emitting-receiving pairs 6a, 6b, 6c are configured as light barriers. Each emitting-receiving pair 6a, 6b, 6c each includes a light emitter 7a, 7b, 7c as well as a light receiver 8a, 8b and 8c. The light receiver 8a, 8b, 8c of each emitting-receiving pair 6a, 6b, 6c is disposed opposing the associated light emitter 7a, 7b, 7c such that the respective light beams 12 - as shown in Fig. 3a and 3b - are directly oriented to the associated light receiver 8a, 8b, 8c. All of the light beams 12 propagate parallel to the circuit board 9.

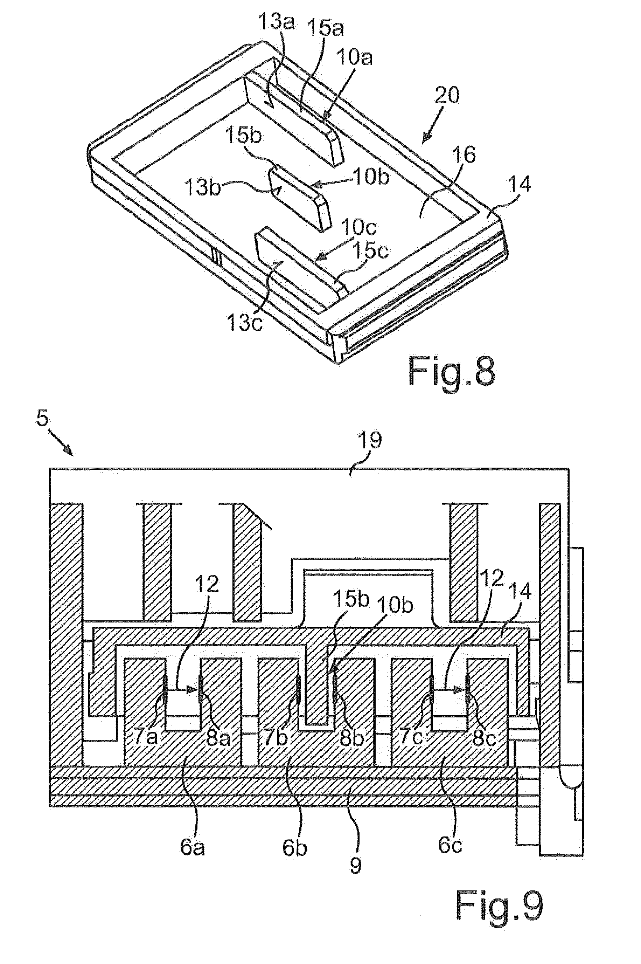

Here too, a common switch element 14 is employed, the bottom 20 of which is shown in more detail in Fig. 8. On the bottom 20 facing the emitting-receiving pairs 6a, 6b, 6c, ribs 15a, 15b, 15c are formed, which protrude perpendicularly towards the respective emitting-receiving pair 6a, 6b, 6c from the plate-shaped base body 16 of the switch element 14. The ribs 15a, 15b, 15c each have an influencing means 10a, 10b, 10c, which are constituted by respective surface areas 13a, 13b, 13c of the ribs 15a, 15b, 15c. These surface areas 13a, 13b, 13c are formed of a light absorbing material and thus opaque.

The first rib 15a can be inserted into a clearance between the light emitter 7a and the light receiver 8a of the first emitting-receiving pair 6a. Correspondingly, the second rib 15b can be inserted into a clearance between the light emitter 7b and the light receiver 8b. The rib 15c can be introduced into a clearance between the light emitter 7c and the light receiver 8c of the third emitting-receiving pair 6c. Therein, the ribs 15a, 15b, 15c extend parallel to the circuit board 9 and are oriented parallel to the direction of movement 18 of the switch element 14.

In this embodiment too, it is differentiated between three state combinations of the light receivers 8a, 8b, 8c and thus between three different positions of the switch element 14:
- a position, in which the light receiver 8a does not receive light beams 12, while the light receivers 8b, 8c receive the light beams 12 from the respective light emitter 7b, 7c;
- a position, in which the central light receiver 8b does not receive light beams 12, while the light receivers 8a, 8c receive the light beams 12 of the respectively associated light emitter 7a, 7c; and
- a position, in which the light receiver 8c does not receive light beams 12, while the light receivers 8a, 8b receive the light beams 12 of the respectively associated light emitter 7a, 7b.

Therein, the central position is shown in Fig. 9, in which a sectional view through the device 5 according to Fig. 7 is illustrated.

In the embodiments, only three state combinations of the light receivers 8a, 8b, 8c are respectively illustrated. The representation of multiple codes and thus multiple state combinations was omitted for the sake of clarity. However, of course, a plurality of state combinations can be realized. For example, with three emitting-receiving pairs 6a, 6b, 6c, it is possible to provide eight different state combinations in total by correspondingly configuring the common switch element 14. To this, multiple ribs can also be provided for one and the same emitting-receiving pair 6a, 6b, 6c, which are disposed distributed next to each other in direction of movement 18. Correspondingly, multiple reflection surfaces or multiple through-openings 17 can also be provided for a single emitting-receiving pair 6a, 6b, 6c.

It is also possible to provide identical influencing means 10a, 10b, 10c - i.e. ribs 15a, 15b, 15c of the same length and/or through-openings 17a, 17b, 17c disposed on the same level - for two emitting-receiving pairs 6a, 6b, 6c such that these emitting-receiving pairs 6a, 6b, 6c experience their state variations at the same points of time. Both emitting-receiving pairs 6a, 6b, 6c then provide the same signals, which has the advantage that after failure of one of these emitting-receiving pairs 6a, 6b, 6c the current switch position of the steering column switch 2 can be further precisely detected. Such an approach can also serve for plausibility check by comparing the signals of these two emitting-receiving pairs 6a, 6b, 6c to each other and then optionally outputting a warning upon a determined deviation.

## Claims

1. Switch device (5) for optoelectronically detecting switch positions of a mechanically operable switch (2) of a motor vehicle, comprising an emitting-receiving pair (6) of a light emitter (7) for emitting light beams (12) and a light receiver (8) for receiving the light beams (12), and comprising an optical influencing means (10) for influencing an optical propagation path (11) of the light beams (12), wherein upon operating the switch (2) the optical influencing means (10) is movable relative to the light emitter (7) and/or the light receiver (8) between a first position, in which the light receiver (8) receives the light beams (12), and a second position, in which incidence of the light beams (12) on the light receiver (8) is prevented,
**characterized in that**
the switch device (5) has at least two emitting-receiving pairs (6) each of a light emitter (7) and an associated light receiver (8) and respectively has an optical influencing means (10) to each emitting-receiving pair (6), wherein the at least two optical influencing means (10) are formed as surface areas (13) of a common switch element (14) and are movable in common with each other upon operating the switch (2).

2. Switch device (5) according to claim 1,
**characterized in that**
the at least two optical influencing means (10) are formed as surface areas (13) of the switch element (14) separate from each other.

3. Switch device (5) according to claim 1 or 2,
**characterized in that**
in each of the at least two emitting-receiving pairs (6), the respective light receiver (8) is disposed fixedly to the associated light emitter (7).

4. Switch device (5) according to any one of the preceding claims,
**characterized in that**
at least one of the influencing means (10) is formed as a reflection surface, which reflects the light beams (12) of the associated light emitter (7) onto the associated light receiver (8) in its first position, and is disposed outside of the light beams (12) of the associated light emitter (7) in its second position.

5. Switch device (5) according to any one of the preceding claims,
**characterized in that**
at least one of the emitting-receiving pairs (6) is formed as a light barrier, in which the light beams (12) of the light emitter (7) are oriented to the light receiver (8), wherein the associated influencing means (10) is disposed outside of the light beams (12) in its first position and intercepts the light beams (12) in its second position.

6. Steering column switch device (1) for a motor vehicle, comprising a mechanically operable steering column switch (2) and including a switch device (5) for optoelectronically detecting switch positions of the steering column switch (2) according to any one of the preceding claims.

7. Motor vehicle with a steering column switch device (1) according to claim 6.

8. Method for optoelectronically detecting switch positions of a mechanically operable switch (2) of a motor vehicle by means of a switch device (5), which has an emitting-receiving pair (6) of a light emitter (7) for emitting light beams (12) and a light receiver (8) for receiving the light beams (12) and an optical influencing means (10) for influencing an optical propagation path (11) of the light beams (12), wherein upon operating the switch (2) the optical Influencing means (10) is moved relative to the light emitter (7) and/or the light receiver (8) between a first position, in which the light receiver (8) receives the light beams (12), and a second position, in which incidence of the light beams (12) on the light receiver (8) is prevented, **characterized in that**
the switch device (5) has at least two emitting-receiving pairs (6) each of a light emitter (7) and an associated light receiver (8) and respectively has an optical influencing means (10) to each emitting-receiving pair (6), wherein the at least two optical influencing means (10) are formed as surface areas (13) of a common switch element (14) and are moved in common with each other upon operating the switch (2).
